(19) Europäisches Patentamt
European Patent Office
Office européen des brevets

(11) **EP 1 758 243 A1**

(12) **EUROPEAN PATENT APPLICATION**

(43) Date of publication:
**28.02.2007 Bulletin 2007/09**

(51) Int Cl.:
*H03F 3/45* (2006.01)     *H03F 1/34* (2006.01)
*H03F 3/00* (2006.01)

(21) Application number: **05107842.6**

(22) Date of filing: **26.08.2005**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(71) Applicant: **Acqiris SA**
**1228 Plan-les-Ouates (CH)**

(72) Inventor: **Adams, Neil**
**01710 Thoiry (FR)**

(74) Representative: **P&TS**
**Patents & Technology Surveys SA**
**Rue des Terreaux 7,**
**Postfach 2848**
**2001 Neuchâtel (CH)**

(54) **Low offset Sample-and-Hold and Amplifier**

(57)     A device and method for correcting the gain induced offset at the input of amplifiers having a finite open-loop gain. The invention may be used advantageously in sample-and-hold circuits, for ensuring that a charge stored in the input, or tracking, capacitor is fully transferred in the hold capacitor. According to an aspect of the invention, a positive feedback is introduced, for compensating the charge loss, or the gain loss, induced by the finiteness of the open-loop gain. The invention can be implemented statically or in a self-calibrating device, which can account for process and environmental fluctuations of the open-loop gain. One or several S/H according to the invention may be used in a cascaded A/D converter.

Fig. 10

EP 1 758 243 A1

**Description**

Field of the invention

The present invention concerns an electronic circuit having a very low input offset error. In particular, but not exclusively, the present invention concerns a sample-and-hold circuit and a digitizer front-end circuit exhibiting a low offset error.

Description of related art

Sample-and-hold stages (in the following abbreviated as S/H) are common in many electronic circuits when an analogue signal needs to be stored for some time. These techniques are very often used, for example, in pipelined analogue to digital converters. In this case a pipelined chain of A/D converters is used to sample the value of signals which are passed between a series of S/H circuits in an array. S/H circuits, however, have several other applications. The input value is usually stored in the form of a voltage across a storage capacitor.

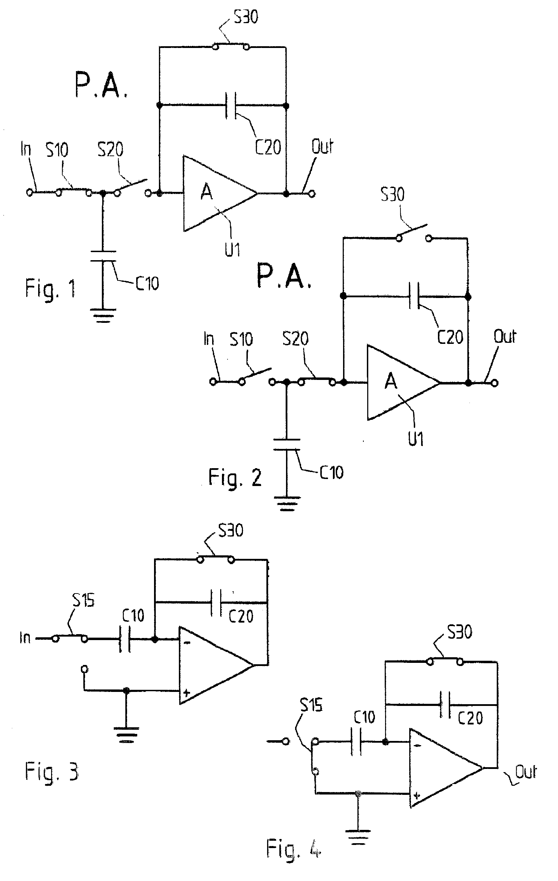

Figures 1 and 2 represent a simplified schematics of a sample-and-hold circuit of known type in the sample mode and in hold mode, respectively. The transition between sample phase and hold phase is determined by the three switches S10, S20 and S30. In the sample mode the input capacitor C10 is connected by the switch S10 to the In node, while the storage capacitor C20 is short-circuited by the reset switch S30.

Upon reception of a hold command, an appropriate circuit (not shown) commands the opening of the switches S10 and S30, and the closing of the switch S20. In this hold mode, shown in figure 2, the input capacitor C10 is discharged into the virtual ground constituted by the input of the operational amplifier U1. The charge of the input capacitor C10 is thus transferred to the storage capacitor C20. In the approximation of a perfect charge transfer, the output voltage in sample mode $V_{out}$ is exactly proportional, by the capacity ratio C10/C20, to the transient value of the In voltage at the sampling instant $V_{In}$. In many cases the S/H will be arranged with C10 = C20, so that $V_{out}=V_{In}$. It is possible however to chose the value of the capacitors in order to obtain a predetermined fixed or variable amplification or attenuation ratio.

However, since no real amplifier gain is infinite, the charge transfer between C10 and C20 will not be complete. It is easy to see in this case, that for a finite open-loop gain A of U1 and assuming, for simplicity, C10=C20, the output value will be given by :

$$V_{Out} = -V_{In} \cdot \frac{A}{A+2} \qquad\qquad (1)$$

At the same time, due to the finite gain A of U1, the sampling capacitor C10 will not be totally discharged into C2, but will retain a residual voltage, in the holding phase which is given by $V_{res} = -V_{Out}/A$.

In general, the formula above is a special case of the classical expression of the transfer function for an operational amplifier using an external negative feedback path:

$$V_{Out} = -V_{In} \bigg/ \left( \frac{1}{N} + \frac{1}{A} \right) \qquad\qquad (2)$$

where $N$ is the negative feedback attenuation from output to input, and $A$ is the open loop gain. According to the case $N$ and $A$ may be real numbers, in the case of a flat response in the bandwidth of interest, or frequency-dependent transfer functions. Formula 1 derives then from formula 2, in the special case of N=1.

The finite open-loop gain of the amplifier induces therefore an input offset in the S/H circuit. This "gain induced offset" is normally of small value and non significant in continuous time signal processing circuits. However, in the case of switched capacitor circuits, and in particular for sample-and-hold circuits at high speed, this incomplete charge transfer can cause severe nonlinearities.

This shortcoming is especially important in the case of pipelined A/D converter comprising an array of S/H circuits used for transferring an analogue value to convert between the individual A/D circuits of the pipeline. In this case the gain induced offset is often responsible of conversion nonlinearities, loss of monotonicity and other defects in the A/D converter which can not be corrected easily.

It is sometimes possible to mitigate the gain induced offset by increasing as much as possible the open-loop gain of the amplifier U1. This is often done by cascading several gain stage and allows, in some applications, to reduce the gain induced offset to tolerable levels. However there is a trade off to be made between single gain stage amplifiers, which have a very broad bandwidth but limited gain, and multi-stage amplifiers which have very high gains, but at the cost of a much lower frequency response. For this reason, the above solution is not adequate for very high speed circuits.

Another limitation of the known circuits is that the gain induced offset is an undesirable effect of the open-loop gain of the amplifier which, however, can vary considerably from one device to another and also depends from external variables like the temperature and the supply voltage. The gain-induced offset is therefore highly dependent from these unaccountable factors and can not be compensated by calibration.

It is an aim of the present invention to provide an analogue storage circuit which is free from the shortcomings of the prior art.

It is another aim of the present invention to provide an analogue storage circuit which exhibit a highly linear response at very high speed.

It is a further aim of the present invention to provide an analogue storage circuit having a very low gain induced offset.

It is a further aim of the present invention to provide a low-offset analogue storage circuit which does not require an individual external calibration of the offset.

Brief summary of the invention

According to the invention, these aims are achieved by means of the devices and methods comprising the features of the attached claims.

In particular the object of the present invention is achieved, according to a first aspect, by an electronic circuit comprising: an amplifier, exhibiting a finite open loop gain and having an output and an input; a negative feedback path, having a negative feedback attenuation coefficient which contributes, together with the open-loop gain, to a closed-loop gain of the amplifier; a positive feedback path, having a positive feedback attenuation coefficient; characterized in that the positive feedback attenuation coefficient and the open-loop gain are so matched as to compensate the effect of the finiteness of the open-loop gain on the closed-loop gain.

According to another aspect, the objects of the invention are achieved by a storage circuit comprising: an amplifier, exhibiting a finite open loop gain and having an output and an input; at least an input capacitor at least a storage capacitor, a negative feedback path between the output and the input of the amplifier, at least a switch, responsive to a hold command, for transferring the charge stored in the input capacitor into the storage capacitor, characterized by a positive feedback path, having a positive feedback attenuation coefficient, wherein the positive feedback attenuation coefficient and the open-loop gain are so matched as to ensure a complete charge transfer from the input capacitor into the storage capacitor.

According to another aspect, the objects of the invention are achieved by a method for compensating the gain induced offset error in a sample-and-hold circuit, the sample and hold comprising: an amplifier, exhibiting a finite open loop gain and having an output and an input; at least an input capacitor; at least a storage capacitor,; a negative feedback path between the output and the input of the amplifier; at least a switch, responsive to a hold command, for transferring the charge stored in the input capacitor into the storage capacitor; a positive feedback path, having a positive feedback attenuation coefficient; the method comprising the step of: varying the open-loop gain and/or the positive feedback attenuation coefficient to ensure a complete charge transfer from the input capacitor into the storage capacitor.

Brief Description of the Drawings

The invention will be better understood with the aid of the description of an embodiment given by way of example and illustrated by the figures, in which:

Fig. 1 shows schematically a conventional Sample-and-Hold circuit of known type in a sampling configuration.

Fig 2 shows schematically the Sample-and-Hold circuit of Figure 1 in a holding configuration.

Figures 3 and 4 show another conventional Sample-and-Hold circuit.

Fig. 5 shows schematically a Sample-and-Hold circuit according to a first aspect of the invention, in a sampling configuration.

Fig 6 shows the Sample-and-Hold Circuit of figure 3 in a Holding configuration.

Fig. 7 represents in a simplified schematic form another aspect of the invention

Fig. 8 and 9 shows schematically a Sample-and-Hold circuit according to a further aspect of the invention, with a differential architecture.

Fig. 10 and 11 shows schematically Sample-and-Hold circuits according to a further aspect of the invention, comprising a self-calibrating means.

Detailed Description of possible embodiments of the Invention

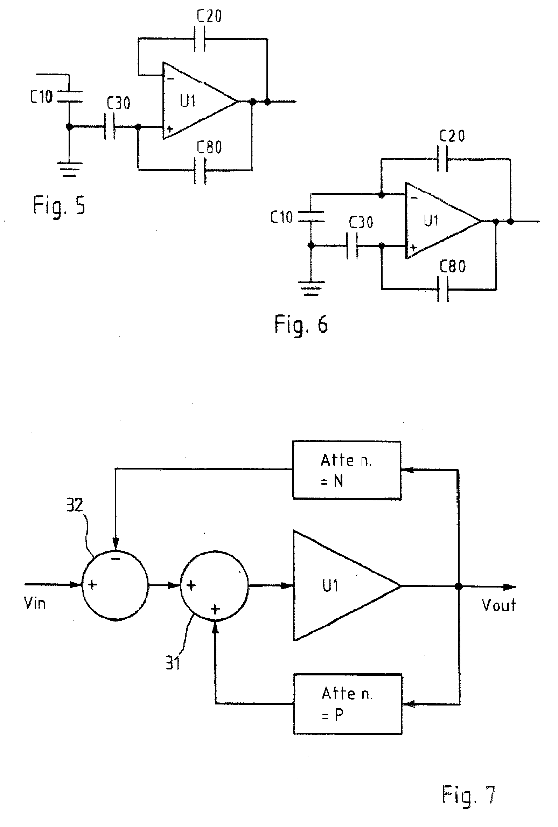

Figures 5 and 6 represent schematically an embodiment of a circuit according to a first aspect of the invention, in a sampling phase, respectively in a holding phase. For the sake of simplicity, the switches which realize the transition of the circuit from a sampling phase to a holding phase, and those which reset the storage capacitor to zero, are not represented.

With reference to figures 5 and 6, according to one aspect of the invention the Sample-and-Hold comprises a positive feedback-loop comprising, for example, the capacitive divider C80, C30 feeding the signal from the output of the amplifier U1 to a non-inverting input of U1. The transfer function of this circuit can be shown to be:

$$V_{Out} = -V_{In} \Big/ \left( \frac{1}{N} + \frac{1}{A} - \frac{1}{P} \right) \qquad (3)$$

In which $P$ represents the positive feedback attenuation from output to input, while $N$ and $A$ are the negative feedback coefficient and the open-loop gain as introduced above. Like $N$ and $A$, $P$ may be approximately constant, at least in a frequency range of interest, for example if the feedback network is entirely composed of capacitors or of resistors. However in the general case $A$, $P$, and $N$ may be functions of the frequency and the feedback networks may include RC combinations or other circuit elements.

Figure 7 shows a generic representation of a circuit according to the invention having a positive feedback path with an attenuation P, a negative feedback path having an attenuation N and two summing nodes 31 and 32.

Returning now to the example of figures 5 and 6, If the values of the capacitors C10, C20, C30 and C89 are chosen in a way that the term $1/P$ exactly cancels $1/A$, the gain of the circuit reduces exactly to $N$, as desired, and the offset term is cancelled out. However, if the circuit architecture is correctly chosen, this has also the effect of cancelling out the gain induced offset seen at the input, in the sense that the sampled charge is completely transferred from the sampling capacitor C10 to the storage capacitor C20.

In particular, the sampling capacitor C10 is no longer connected between the inputs of U1 and, therefore, the output of U1 is no longer proportional to the residual voltage on C10, but the required input offset voltage is provided by the negative voltage present on C30. In particular, if the compensation P=A is exact, the residual voltage left across the sampling capacitor C10 is exactly zero in the hold phase of figure 6.

The stability of the circuit of figures 5 and 6 requires that the denominator of the transfer function of equation (3) does not approach zero. It can be seen that, for typical values found in switched-capacitor circuit, the factor N is typically in the range 1-10, while the open-loop gain A (and hence the factor P which we are trying to realize) in the range 100-10000, thus the negative feedback is sufficiently large to prevent instability in most cases. If needed, however, a frequency roll-off may be introduced in the positive feedback path, to further improve stability, at the expense of some response speed.

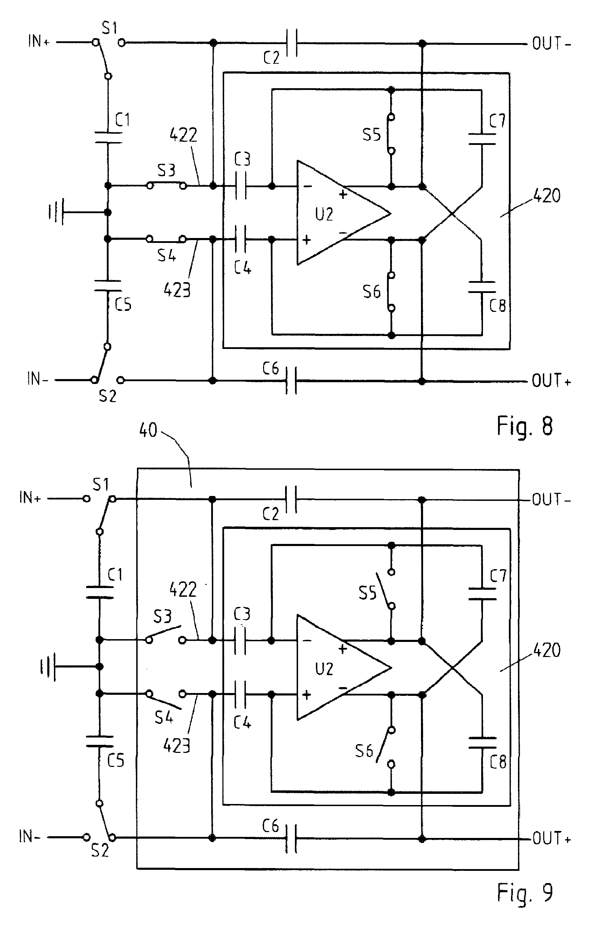

Figures 8 and 9 represent, in the sample phase and in the hold phase, a circuit according to a fully differential embodiment of the present invention. In this case the signal is given by the voltage difference between the differential input nodes In+ and In-, and is sampled, in the sample state, in the sampling capacitors C1 and C5, via the switches S1 and S2. The positive feedback path and the negative feedback path have preferably a symmetrical differential disposition.

The storage circuit 40 comprises an amplifier U2 having two complementary outputs Out+ and Out-, and the storage capacitors C2, C6 which are kept in a reset state, during the sample phase, by the switches S5 S6, S3, and S4.

During the hold phase, as represented in figure 9, the switches S1, S2, connect the storage capacitors C1, C5 with the storage circuit 40, while the switches S3, S4, S5, S6 are open. The positive feedback in the hold phase is provided by capacitors C7, C3 for the Out- output and C8, C4 for the Out+ output, while the negative feedback is ensured by the storage capacitors C2, respectively C6.

The circuit block 420 of figures 8 and 9 includes the finite-gain amplifier U2 together with the feedback network constituted by capacitors C3, C4, C7 and C8. Capacitors C3, C4, C7 are dimensioned in order to introduce an positive feedback attenuation P which compensates exactly the finite open-loop gain $A$ if U2, at least in a frequency range of interest. In this way the circuit block 420 is effectively an infinite-gain differential amplifier with inputs 422 and 423.

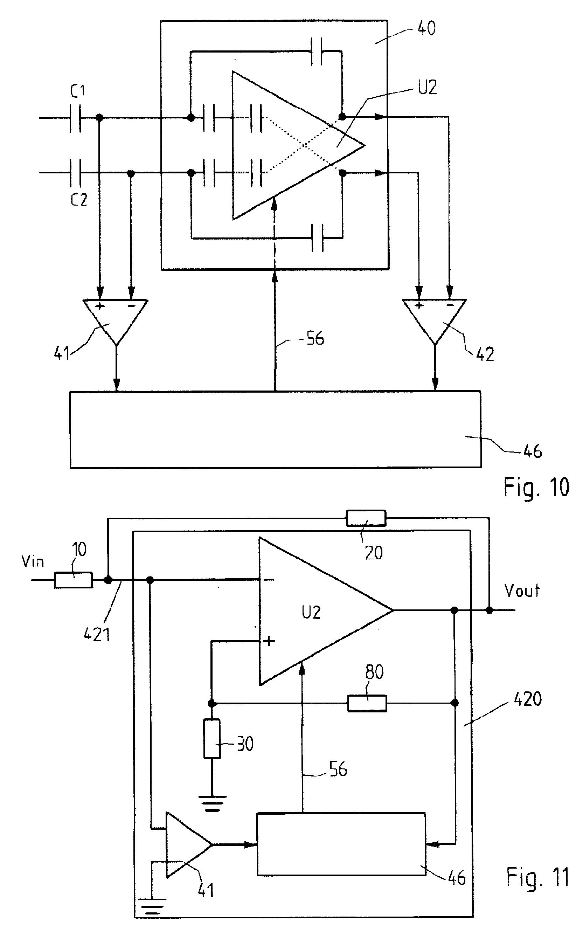

Also, in many practical realizations, the attenuation to be given to the positive feedback loop would not be exactly known, because it depends from the amplifier open-loop gain, which is a function of process, bias current and temperature. Figure 10 represents an embodiment of the present invention which is self-calibrating, and provides exact compensation of the gain induced offset in presence of an unknown and variable open-loop gain A.

The circuit of figure 10 utilizes the fact that an exact equality of $A$ and $P$ is characterized by a complete charge transfer, while a mismatch between the open-loop gain $A$ and the positive feedback factor $P$ is indicated by a residual voltage across the input capacitors in the hold phase.

According to this embodiment of the invention, the amplifier U2 has a variable open-loop gain, selectable by means of a gain control signal 56. The variation of the gain could be obtained, for example, by acting on the bias current of one or more stages in the amplifier, or by a variable attenuator, or by any other appropriate means.

A differential amplifier 41 senses the residual voltage $V_{res}$ on the input capacitors C1, C2 at an appropriate moment during the hold phase, for example at the end of a transfer cycle, or after a predefined settling time from the sampling command. At the same time, the differential output voltage $V_{out}$ is sensed by amplifier 42 and fed to the gain control block 46. The gain control block 46 is arranged to adjust the open-loop gain of the amplifier U2, depending on the values $V_{res}$ and $V_{out}$.

In particular, the gain control block aims to set a gain A which provides a zero value of $V_{res}$. This corresponds to a perfect charge transfer and to an optimal offset, according to the relationship:

$$V_{res} = V_{out} \cdot \left( \frac{1}{P} - \frac{1}{A} \right) \qquad (4)$$

In a variant of this embodiment, the value of $V_{out}$ is not used; the gain control block increases or decreases the open-loop gain A depending on the amplitude sign of $V_{res}$, until a zero condition is obtained.

In a further variant of this aspect of the invention, the gain control block 46 acts on the positive feedback coefficient $P$, for example modifying the value of C80 and/or of C20, in order to set a positive feedback level which compensates exactly the input offset induced by the finite gain $A$ of U2.

In a further variant of the embodiments of the invention described above, the capacitors C10, C20, C30, C80, C1, C2, C3, C4, C5, C6, C7, C8 may be replaced, all or in part, by other circuit elements, for example resistors, RC networks, inductors, generic circuit elements having a complex impedance or any appropriate circuit element. Also the switches may be suppressed if a continuous signal implementation is desired.

A variant embodiment of the present invention consisting in an unswitched circuit for continuous signals is now described in more detail with reference to figure 11. According to this aspect of the invention, the circuit comprises an amplifier U2, for example an operational amplifier, having an open-loop gain $A$ connected as inverting amplifier by means of resistors 10 and 20 creating a negative feedback loop.

The non-inverting input terminal (+) of U2 is not tied to a fixed reference potential. A positive feedback loop, constituted by resistances 80 and 30 is dimensioned in a manner to compensate, at least in a frequency range, the gain induced input offset, for a given open-loop gain A of the amplifier U2. In this condition, and according to formula (3), the closed-loop gain from $V_{in}$ to $V_{out}$ is given exactly by the ratio of resistors 20 and 10. The circuit block 420 is an infinite-gain amplifier with no input offset at the amplifier 421 input, the offset having been transferred to the non-inverting input of U2 in a manner to exactly compensate the finiteness of the open-loop gain of amplifier U2.

In order to compensate for variations of the open-loop gain A of U2, a gain control circuit 46 may be included, as explained in the previous embodiment. Advantageously, the gain control circuit 46 directly modifies the open-loop gain A of U2, depending from the values of the input voltage V-, given by the buffer 41, and from the output voltage $V_{out}$. In a variant embodiment the gain-control circuit 46 may act directly on the positive feedback attenuation P, modifying the value of resistor 80 and/or resistor 30.

In a further variant of this embodiment one or more of resistors 10, 20, 30, 80 may be replaced by circuit elements having complex impedance, for example a RC circuit, or by other circuit elements.

This example referred, for the sake of simplicity, to a single-ended realization, it is to be understood, however, that this embodiment of the invention may be implemented, like the previous ones, with an amplifier having differential input and output, the positive and negative feedback networks having a symmetrical differential disposition.

The various embodiment of the present invention utilize real amplifiers whose open-loop gain A is not in general constant, but variable depending from the frequency of the signal. In this situation it may be difficult to match the open loop gain $A$ in an extended frequency range. It is to be understood that the circuit of the invention may be arranged in order to compensate the gain induced input offset, for a determined frequency or in a restricted frequency range, in which the signal of interest is mostly found. Equivalently, in the time domain, the circuits of the invention may be arranged in such way that the positive feedback coefficient $P$ compensates the error induced by the finiteness of the open-loop gain $A$ within certain defined time limits, for example after a certain settling time from the arrival of an impulsive signal, or from the switching of the circuit's operating mode.

For example, a S/H circuit according to the present invention may have a positive feedback coefficient $P$ which is chosen in such a way that the output signal, after an initial settling transient, equals the value of the input signal at the time in which the is compensates the error induced by the finiteness of the open-loop gain $A$.

**Claims**

1. Electronic circuit comprising:

   - an amplifier (U1, U2), exhibiting a finite open loop gain (A) and having an output and an input;
   - a negative feedback path (C20, C10; C2, C1; 20, 10), having a negative feedback attenuation coefficient (N) which contributes, together with the open-loop gain (A), to a closed-loop gain of the amplifier;

   a positive feedback path (C30, C80; C3, C4, C7, C8; 30, 80), having a positive feedback attenuation coefficient (P);
   **characterized in that**
   the positive feedback attenuation coefficient (P) and the open-loop gain (A) are so matched as to compensate the effect of the finiteness of the open-loop gain (A) on the closed-loop gain.

2. Electronic circuit according to the preceding claim, further **characterized in that** the positive feedback attenuation coefficient (P) and the open-loop gain (A) are so matched as to zero an offset at the input of the amplifier (U1, U2).

3. Electronic circuit according to one of the preceding claims, further **characterized in that** the positive feedback attenuation coefficient (P) and the open-loop gain (A) are so matched as to provide an infinite-gain amplifier (420)

4. Electronic circuit according to one of the preceding claims, wherein the open-loop gain (A) of the amplifier and/or the positive feedback attenuation coefficient (P) are variable and further comprising a gain control section (46), acting on the open-loop gain (A) of the amplifier and/or the positive feedback attenuation coefficient (P) for matching the open-loop gain (A) of the amplifier and the positive feedback attenuation coefficient (P) to compensate the effect of the finiteness of the open-loop gain (A) on the closed-loop gain.

5. Electronic circuit according to the preceding claim, wherein the gain control section (46) is responsive to the offset at the input of the amplifier (U1, U2).

6. Electronic circuit according to the preceding claim, wherein the gain control section (46) is responsive to the output of the amplifier.

7. Electronic circuit according to one of the preceding claims, wherein the input and the output of the amplifier (U1, U2) are differential, the positive feedback path and the negative feedback path having a symmetrical differential disposition.

8. Electronic circuit according to one of the preceding claims, wherein the open-loop gain (A) and the positive feedback attenuation coefficient (P) are matched in a determined frequency interval.

9. Storage circuit comprising:

   an amplifier (U1, U2), exhibiting a finite open loop gain (A) and having an output and an input;
   at least an input capacitor (C1, C5; C10)
   at least a storage capacitor, (C20, C2, C6)
   a negative feedback path between the output and the input of the amplifier (C20, C2, C3; C6, C4),
   at least a switch (S20; S3, S4), responsive to a hold command, for transferring the charge stored in the input capacitor (C1, C5; C10) into the storage capacitor, (C20, C2, C6),

   **characterized by** a positive feedback path (C30, C80; C3, C4, C7, C8), having a positive feedback attenuation coefficient (P), wherein the positive feedback attenuation coefficient (P) and the open-loop gain (A) are so matched as to ensure a complete charge transfer from the input capacitor (C1, C5; C10) into the storage capacitor, (C20, C2, C6).

**10.** Storage circuit according to the preceding claim, wherein the positive feedback attenuation coefficient (P) and the open-loop gain (A) are so matched as to compensate the effect of the finiteness of the open-loop gain (A) on a closed-loop gain of the amplifier.

**11.** Storage circuit according to one of claims 9 or 10, wherein the open-loop gain (A) of the amplifier and/or the positive feedback attenuation coefficient (P) are variable and further comprising a gain control section (46), acting on the open-loop gain (A) of the amplifier and/or the positive feedback attenuation coefficient (P) for matching the open-loop gain (A) of the amplifier and the positive feedback attenuation coefficient (P) to ensure a complete charge transfer from the input capacitor (C1, C5; C10) into the storage capacitor, (C20, C2, C6).

**12.** Storage circuit according to the preceding claim, wherein the gain control section (46) is responsive to the residual voltage on the input capacitor (C1, C5; C10) after the hold command.

**13.** Storage circuit according to the preceding claim, wherein the gain control section (46) is responsive to the output of the amplifier.

**14.** Storage circuit according to one of the claims from 9 to 13, wherein the input and the output of the amplifier (U1, U2) are differential, the positive feedback path and the negative feedback path having a symmetrical differential disposition.

**15.** Sample-and-Hold circuit according to one of claims from 9 to 14.

**16.** Method for compensating the gain induced offset error in a sample-and-hold circuit, the sample and hold comprising:

an amplifier (U1, U2), exhibiting a finite open loop gain (A) and having an output and an input;
at least an input capacitor (C1, C5; C10);
at least a storage capacitor, (C20, C2, C6);
a negative feedback path between the output and the input of the amplifier (C20, C2, C3; C6, C4);
at least a switch (S20; S3, S4), responsive to a hold command, for transferring the charge stored in the input capacitor (C1, C5; C10) into the storage capacitor (C20, C2, C6);
a positive feedback path (C30, C80; C3, C4, C7, C8), having a positive feedback attenuation coefficient (P);
the method comprising the step of:
varying the open-loop gain and/or the positive feedback attenuation coefficient (P) to ensure a complete charge transfer from the input capacitor (C1, C5; C10) into the storage capacitor, (C20, C2, C6).

**17.** Method according to the preceding claim, further comprising a step of measuring the residual amount of charge in the input capacitor (C20, C2, C6), the variation of the open-loop gain and/or of the positive feedback attenuation coefficient (P) aiming at the minimization of the residual charge in the input capacitor.

**18.** Analogue to digital converter comprising at least one sample-and-hold circuit according to claim 15.

**19.** Cascaded analogue to digital converter comprising a pipelined chain of sample-and-hold circuits according to claim 15.

P.A.

Fig. 1

P.A.

Fig. 2

Fig. 3

Fig. 4

Fig. 5

Fig. 6

Fig. 7

Fig. 8

Fig. 9

Fig. 10

Fig. 11

**European Patent Office**

## EUROPEAN SEARCH REPORT

Application Number

EP 05 10 7842

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2003/155967 A1 (FUJIMOTO YOSHIHISA) 21 August 2003 (2003-08-21) * paragraphs [0094] - [0142]; figures 1,2 * | 1-19 | H03F3/45 H03F1/34 H03F3/00 |
| X | US 5 034 699 A (POWELL ET AL) 23 July 1991 (1991-07-23) * column 2, lines 18-54; figure 2 * | 1-6,8 | |
| X | US 4 079 331 A (PINCKAERS ET AL) 14 March 1978 (1978-03-14) * column 2, line 20 - column 5, line 11; figure 1 * | 1-6,8 | |
| A | US 5 847 600 A (BROOKS ET AL) 8 December 1998 (1998-12-08) * the whole document * | 1-19 | |
| A | EP 0 243 792 A (INTERNATIONAL BUSINESS MACHINES CORPORATION) 4 November 1987 (1987-11-04) * the whole document * | 1-6,8 | TECHNICAL FIELDS SEARCHED (IPC) |
| A | PATENT ABSTRACTS OF JAPAN vol. 2000, no. 19, 5 June 2001 (2001-06-05) & JP 2001 043504 A (SONY CORP), 16 February 2001 (2001-02-16) * abstract * | 1-6,8 | H03F |

The present search report has been drawn up for all claims

| Place of search | Date of completion of the search | Examiner |
|---|---|---|
| The Hague | 9 December 2005 | Fedi, G |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 05 10 7842

This annex lists the patent family members relating to the patent documents cited in the above-mentioned European search report.
The members are as contained in the European Patent Office EDP file on
The European Patent Office is in no way liable for these particulars which are merely given for the purpose of information.

09-12-2005

| Patent document cited in search report | | Publication date | Patent family member(s) | | Publication date |
|---|---|---|---|---|---|
| US 2003155967 | A1 | 21-08-2003 | JP 3621385 B2 | | 16-02-2005 |
| | | | JP 2003243949 A | | 29-08-2003 |
| US 5034699 | A | 23-07-1991 | JP 5175762 A | | 13-07-1993 |
| US 4079331 | A | 14-03-1978 | CA 1092202 A1 | | 23-12-1980 |
| US 5847600 | A | 08-12-1998 | NONE | | |
| EP 0243792 | A | 04-11-1987 | DE 3768847 D1 | | 02-05-1991 |
| | | | JP 1874828 C | | 26-09-1994 |
| | | | JP 5085085 B | | 06-12-1993 |
| | | | JP 62261205 A | | 13-11-1987 |
| | | | US 4707667 A | | 17-11-1987 |
| JP 2001043504 | A | 16-02-2001 | NONE | | |

EPO FORM P0459

For more details about this annex : see Official Journal of the European Patent Office, No. 12/82